# EUROPEAN PATENT APPLICATION

(11) **EP 4 542 870 A1**
(43) Date of publication of application: **23.04.2025**
(21) Application number: 23203888.5
(22) Date of filing: 16.10.2023
(51) Int. Cl.: H04B 3/46

(54) **NETWORK NODE FOR A MULTIDROP SINGLE PAIR ETHERNET AND CORRESPONDING METHOD**

(71) Applicant: NXP B.V., 5656 AG Eindhoven (NL)
(72) Inventor: de Haas, Clemens Gerhardus Johannes, 5656 AG Eindhoven (NL)
(74) Representative: Schmütz, Christian Klaus Johannes

(57) **Abstract**

The present disclosure relates to a network node comprising a transceiver, that is galvanically isolated coupled to the network terminals of the network node, wherein the network not also comprises a test unit, which is galvanically connected to the network nodes, such that the test unit can apply a predefined common mode voltage at the network terminals and also configured to detect a structural fault of a network, which may be connected to the network terminals. The present disclosure also relates to a corresponding system and method.

## Description

### TECHNICAL FIELD

The present disclosure relates to a network node for a multidrop single pair Ethernet and a corresponding method.

### BACKGROUND

Ethernet is a well-known network technology, and the Institute of Electrical and Electronic Engineers (IEEE) 802.3 Working Group is a collection of standards that define physical layer and data link layer media access control (MAC) for wired Ethernet. For example, modern automobiles include various electronic communication device, also referred to as network node, that communicate with each other in an automobile via in-vehicle network (IVN) technologies such as Ethernet. An emerging IEEE standard that may be particularly applicable to in-vehicle networks is IEEE 802.3cg, which is a specification for 10 Megabits per second (Mb/s) over single twisted-pair cable that enables multiple network nodes to connect to the same twisted-pair cable, also referred to as a "shared media." Being able to connect several network nodes in a cost-effective way is a motivation that drives the use of the IEEE 802.3cg (10BASE-T1). The goals of IEEE 802.3cg is to define a point-to-point and a multidrop short-distance standard with a maximum length of 25 meters, and a long-distance point-to-point standard that supports distances up to 1,000 meters. The resulting IEEE 802.3cg specification includes two link-layer standards: 10BASE-T1S and 10BASE-T1L.

The 10BASE-T1S short-range standard is primarily targeted at automotive and industrial applications. Multiple network nodes on the 10BASE-T1S Ethernet network can share twisted twisted-pair cable in half-duplex shared-medium mode (multidrop mode) using the standard Ethernet Carrier-Sense Multiple Access with Collision Detection (CSMA/CD) access method or operate using PHY-Level Collision Avoidance (PLCA). The cable is an unshielded twisted pair (UTP) that may have multiple medium dependent interfaces (MDIs) attached thereto. Each MDI may be allocated to a dedicated network node. As such, 10BASE-T1S may also be referred to as Multidrop Single Pair Ethernet (MSPE).

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a network node is provided, wherein the network node comprising: a network interface for connecting to two-wire network lines, a transceiver, and a test unit, wherein the network interface comprises a first network terminal for connecting to a first of the two network lines and a second network terminal for connecting to a second of the two network lines, wherein the transceiver is coupled to the network terminals, wherein the transceiver is configured to generate a transmit signal at the network interface representing an Ethernet packet, wherein the test unit is galvanically connected coupled to the network terminals, and wherein the test unit is configured to detect a short circuit between the network terminals, a short circuit between the network lines and/or a short circuit between one of the network lines and a supply voltage of the network node, and/or to detect a break in at least one of the network lines.

In one or more embodiments, the transceiver is galvanically isolated coupled to the network terminals.

In one or more embodiments, the transceiver is capacitively coupled to the network terminals.

In one or more embodiments, the transceiver is galvanically connected coupled to the network terminals.

In one or more embodiments, the test unit is galvanically connected coupled to the network terminals via the transceiver.

In one or more embodiments, the test unit comprises a driver unit configured to cause a reference common mode voltage at the network terminals, wherein the test unit comprises a first sensor unit galvanically connected to both network terminals, wherein the first sensor unit configured to detect an actual common mode voltage at the network terminals, wherein the test unit is configured to detect a first short circuit between one of the network lines and a supply voltage of the network node based on a voltage difference between the reference common mode voltage and the actual common mode voltage.

In one or more embodiments, the test unit comprises the or a driver unit configured to cause a reference common mode voltage at the network terminals, wherein the test unit comprises a second sensor unit galvanically connected to both network terminals, wherein the second sensor unit configured to directly or indirectly detect an impedance referred to as terminal impedance between the network terminals, wherein the test unit is configured to detect, based on the terminal impedance: a second short circuit between the network lines, and/or a first break in one of the network lines, and/or a termination error at the network lines and/or network terminals.

In one or more embodiments, the test unit is configured to detect the second short circuit if the terminal impedance is smaller than a first reference impedance, and/or wherein the test unit is configured to detect the first break if the terminal impedance is larger than the second reference impedance and in particular smaller than a third reference impedance, wherein the second reference impedance being larger than the first reference impedance, and/or wherein the test unit is configured to detect the termination error if the terminal impedance is greater than the third reference impedance.

In one or more embodiments, the test unit comprises a driver unit configured to cause a reference common mode voltage at the network terminals, wherein the test unit comprises a third sensor unit galvanically connected to the first network terminal, wherein the third sensor unit configured to detect a voltage referred to as the first measurement voltage at the first network terminal, the test unit being configured to detect based on the first measurement voltage: a first short circuit between one of the network lines and a supply voltage of the network node, and/or a second short circuit between the network lines, and/or a first break in one of the network lines, and/or a termination error at the network lines and/or network terminals.

In one or more embodiments, the test unit comprises a driver unit configured to cause a reference common mode voltage at the network terminals, wherein the test unit comprises a third sensor unit galvanically connected to the first network terminal, wherein the third sensor unit configured to detect a voltage referred to as the first measurement voltage at the first network terminal, wherein the test unit is configured to compare the first measurement voltage with a reference voltage resulting in a first comparison result, the test unit being configured to detect based on the first comparison result: a first short circuit between one of the network lines and a supply voltage of the network node, and/or a second short circuit between the network lines, and/or a first break in one of the network lines, and/or a termination error at the network lines and/or network terminals.

In one or more embodiments, the test unit is configured to detect the second short circuit if the first measurement voltage is smaller than a first reference voltage, and/or wherein the test unit is configured to detect the first break if the first measurement voltage is larger than the second reference voltage and in particular smaller than a third reference voltage, where the second reference voltage being larger than the first reference voltage, and/or wherein the test unit is configured to detect the termination error if the first measurement voltage is greater than the third reference voltage.

In one or more embodiments, the test unit comprises a first comparator to compare the first measurement voltage with the first reference voltage, wherein the test unit comprises a second comparator to compare the first measurement voltage with the second reference voltage, and wherein the test unit comprises a third comparator to compare the first measurement voltage with the third reference voltage.

In one or more embodiments, the test unit is configured to drive the reference voltage to each of the first reference voltage, second reference voltage and third reference voltage, and wherein the test unit comprises a comparator to compare the first measurement voltage with the reference voltage at each level driven by the test unit.

In one or more embodiments, a part of the driver unit is formed by the transceiver, and/or wherein the sensor unit is coupled to the network interface via the transceiver.

In one or more embodiments, the test unit comprises a driver unit configured to generate a first reference voltage at the first network terminal and to generate a second reference voltage at the second network terminal that is less than the first reference voltage, wherein the test unit comprises a sensor unit configured to detect a voltage referred to as the first measurement voltage at the first network terminal, the sensor unit being configured to detect a voltage referred to as a second measurement voltage at the second network terminal, the test unit being configured to detect based on the first measurement voltage and the second measurement voltage: a first short circuit between one of the network lines and a supply voltage of the network node, a second short circuit between the network lines, a first break in one of the network lines, and/or the first break in one of the network lines and a second break in the other network line.

In one or more embodiments, the test unit comprises a driver unit configured to generate a first reference voltage at the first network terminal and to generate a second reference voltage at the second network terminal that is less than the first reference voltage, wherein the test unit comprises a sensor unit configured to detect a voltage referred to as the first measurement voltage at the first network terminal, the sensor unit being configured to detect a voltage referred to as a second measurement voltage at the second network terminal, wherein the test unit is configured to compare the first measurement voltage with the first reference voltage resulting in a first comparison result, wherein the test unit is configured to compare the second measurement voltage with the second reference voltage resulting in a second comparison result, wherein the test unit is configured to detect, based on the first comparison result and the second comparison result: a first short circuit between one of the network lines and a supply voltage of the network node, a second short circuit between the network lines, a first break in one of the network lines, and/or the first break in one of the network lines and a second break in the other network line.

In one or more embodiments, the test unit is configured to incrementally increase the first reference voltage, wherein the test unit is configured to compare the first measurement voltage to each first reference voltage resulting in respective associated first comparison results, wherein the test unit is configured to incrementally decrease the second reference voltage, wherein the test unit is configured to compare the second measurement voltage with each second reference voltage resulting in respective second comparison results, wherein the test unit is configured to detect, based on the first comparison results and the second comparison results: a first short circuit between one of the network lines and a supply voltage of the network node, a second short circuit between the network lines, a first break in one of the network lines, and/or the first break in one of the network lines and a second break in the other network line.

According to a second aspect of the present disclosure, a system is provided, which comprises: a network node referred to as a primary network node according to any of the preceding claims, at least one another different network node referred to as secondary network node, and a two-wire network, wherein each secondary network node comprises a transceiver, wherein each secondary network node comprises a network interface for connecting to the network lines of the two-wire network, wherein the network interface of each secondary network node comprises a first network terminal for connecting to a first of the two network lines and a second network terminal for connecting to a second of the two network lines, wherein the transceiver of each secondary network node is coupled to the network terminals of the respective network node in a galvanically isolated manner, wherein the transceiver of each secondary network node is configured to generate a transmit signal at the network interface representing an Ethernet packet, and wherein each network node is galvanically connected coupled to the network lines via the associated network interface.

According to a third aspect of the present disclosure, a method for a network node is disclosed, which comprises a network interface for connecting to a two-wire network, a transceiver, and a test unit, wherein the network interface comprises a first network terminal for connecting to a first of the two network lines and a second network terminal for connecting to a second of the two network lines, wherein the transceiver is coupled to the network terminals, wherein the transceiver is configured to generate a transmit signal at the network interface representing an Ethernet packet, wherein the test unit is galvanically connected coupled to the network terminals, and wherein the method comprises the step of: Detecting a short circuit between the network terminals, a short circuit between the network lines and/or a short circuit between one of the network lines and a supply voltage of the network node via the test unit.

In accordance with a fourth aspect of the present disclosure, a computer program is provided, comprising executable instructions which, when executed by a processing unit of the network node, cause the processing unit being configured to carry out the method of the third aspect and/or one or more embodiments thereof.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 shows a simplified block diagram of an embodiment of a system.
Figure 2 shows a simplified block diagram of a secondary network node.
Figure 3 shows a simplified block diagram of an embodiment of the system.
Figure 4-6 show embodiments of a simplified block diagram of a primary network node.
Figures 7-10 show embodiments of a simplified block diagram of embodiments of a test unit.
Figure 11 shows a simplified flow chart.

### DESCRIPTION OF EMBODIMENTS

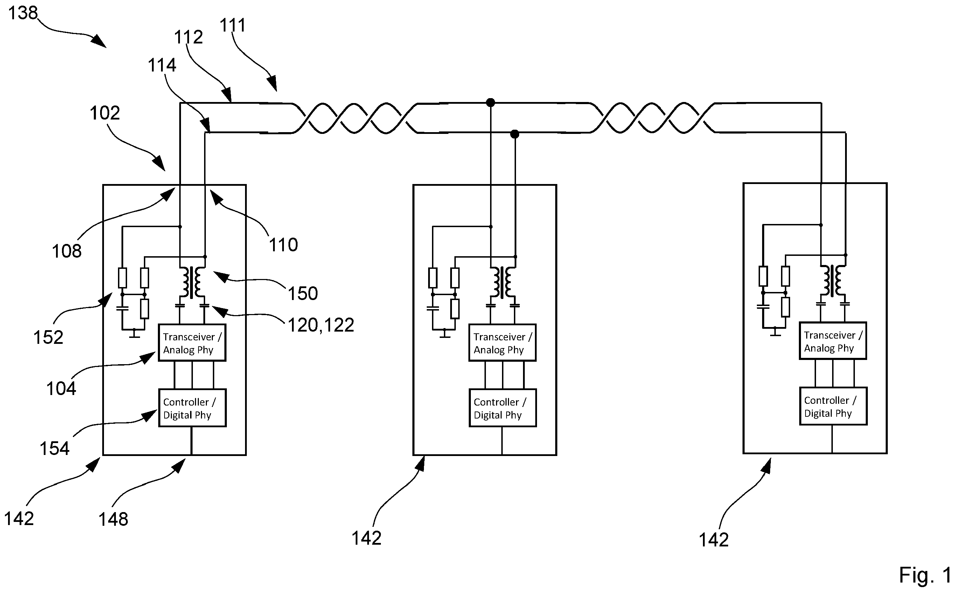

Figure 1 schematically illustrates an embodiment of a system 138. The system 138 may also be referred to as an Ethernet communication system 138. The system 138 comprises a plurality of network nodes 142. Each network node 142 may be a device, in particular a communication device. In addition, the system 138 comprises a two-wire network cable 111, which may also be referred to as two-wire network cable 111. The two-wire network cable 111 comprises a first wire, which may also be referred to as a first network line 112. Further, the two-wire network cable 111 comprises a second wire, which may also be referred to as the second network line 114. The first and second network wires 112,114 are twisted.

Each network node 142 of the system 138 comprises an interface 102, which may be referred to as a network interface 102. Each network node 142 is connected to the two-wire network cable 111 via the associated network interface 102. As a result, the network nodes 142 may be connected in parallel to the two-wire network cable 111. Such an arrangement is also referred to as a multidrop system. The system 138 may comprise a plurality of network nodes 142, each coupled in parallel via the two-wire network cable 111. The two-wire network cable 111 may act as a bus that couples the network nodes 142 together.

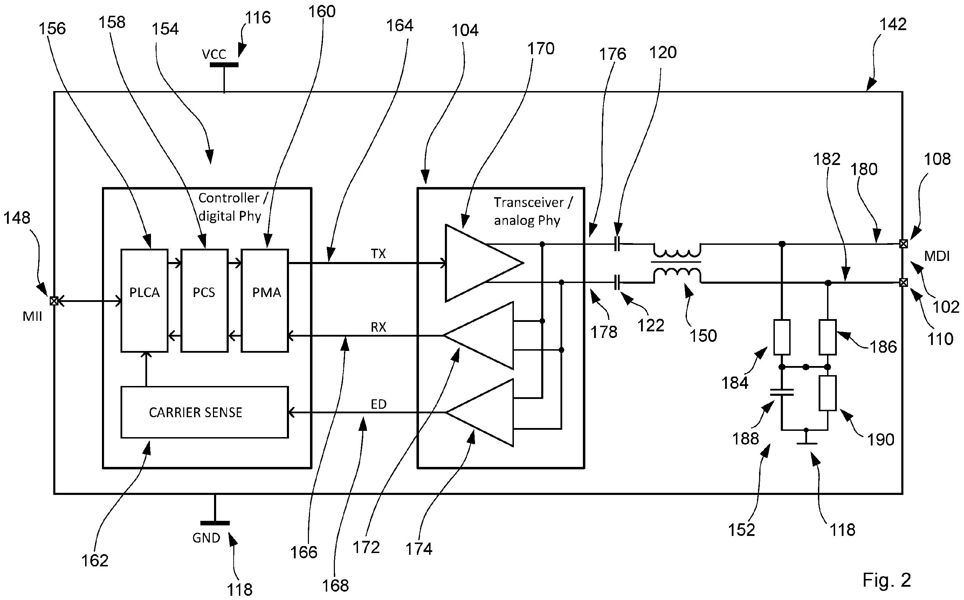

Figure 2 schematically illustrates an embodiment of a network node 142. The network node 142 of the system 138 comprises a transceiver 104 that is capacitively coupled to the network interface 102 of the network node 142. The transceiver 104 is configured to generate a transmit signal at the network interface 102 representing an Ethernet packet. The Ethernet packet is preferably an Ethernet packet according to the 10Base-T1s standard. The 10Base-T1s standard is documented in IEEE 802.3cg.

The transceiver 104 of the network node 142 is only capacitively connected to the network interface 102 of the respective network node 142. As an effect, the transceiver 104 of the network node 142 is galvanically isolated from the network interface 102 of the network node 142. In an example, the network node 142 comprises at least two capacitors 120, 122 integrated into connections 180, 182 between the transceiver 104 and the network interface 102 such that no galvanic electrical connection is formed, but only a capacitive coupling. In an example, a choke 150 may be integrated into connections 180, 182. In an example, the choke 150 may be a common mode choke 150.

In an example, the first signal connection 180 may extend from a first transceiver terminal 176 of the transceiver 104 to a first terminal 108 of the network interface 102. The first terminal 108 may also be referred to as the first network terminal 108 of the network interface 102. In an example, the second signal connection 182 may extend from a second transceiver terminal 178 to a second terminal 110 of the network interface 102. The terminal 110 may also be referred to as the second network terminal 110 of the network interface 102.

In an example, the first signal connection 180 and the second signal connection 182 may extend in parallel from the transceiver 104 to the network interface 102. The choke 150 may be integrated into the first and second signal connections 180, 182. The first signal connection 180 may integrate the first capacitor 120. The second signal connection 182 may integrate the second capacitor 122.

The common mode choke 150 may be used to filter interfering common mode signals. In an example, the common mode choke 150 may serve to suppress common mode interference.

The first capacitor 120 and the second capacitor 122 may each comprise, for example, a capacitance of 100 nF and/or have an isolation voltage of at least 50 V. The first and second capacitors 120 are inexpensive. The first and second capacitors 120 protect the transceiver 104 from excessive voltage that can occur during a short circuit to an external DC voltage.

Each network node 142 may further comprise a termination network 152. The termination network 152 may be an H-shaped network. A first arm of the termination network 152 may include a first resistor 184, a second arm of the termination network 152 may include a second resistor 186, a third arm of the termination network 152 may include a third resistor 190, and a fourth arm of the termination network 152 may include a capacitor 188. The first arm may further be coupled to the first signal connection 180, and the second arm may be coupled to the second signal connection 182. The third and fourth arms may each be coupled to a second voltage supply terminal 118 of the network node 142. The first, second, third, and fourth arms may further be coupled together in a star configuration.

The first resistor 184 and the second resistor 186 may each comprise an electrical resistance of 50 ohm. The electrical resistance of 50 ohm is often used if the network node 142 is used as a network node 142 at the end of a network cable 111. If the network node 142 is connected to the network cable 11 between its ends, then the network node may not comprise a termination network 152 or if it comprises a termination network 152, then the first resistor 184 and the second resistor 186 may each comprise an electrical resistance of 1.5 kilo ohms. The third resistor 186 may comprise an electrical resistance of 100 ohm. The capacitor 188 may comprise a capacitance of 100 nF. The first and second resistor 184, 186 may terminate the first and second network terminals 108, 110. The first and second resistor 184, 186 each comprise the same electrical resistance. The node between the two resistors 184, 186 is coupled to the second voltage supply terminal 118 via the parallel circuit formed by the third resistor 190 and the capacitor 188 so that a common mode voltage at the node can be brought into balance with an electrical voltage at the second voltage supply terminal 118.

In an example, the network node 142 comprises a controller 154. The controller 154 may also be referred to as a digital physical layer (PHY) 154. The transceiver 104 may also be referred to as the analog PHY or analog front-end (AFE) 104. The controller 154 may be coupled to an interface 148 of the network node 142. In an example, the controller 154 may receive digital data and/or send digital data via the interface 148. The controller 154 may be coupled to the transceiver 104 via a transmit data, TX, signal connection 164. The controller 154 may send transmit data to the transceiver 104 via the TX signal connection 164. The transceiver 104 may comprise a transmitter unit 170, which may also be referred to as a transmitter 170. The transceiver 104 may be configured to generate a transmit signal at the transceiver terminals 176, 178 via the transmitter unit 170 and based on received transmit data such that the transmit signal represents the transmit data. The transmit signal may be a differential voltage signal between the two transceiver terminals 176, 178. The transceiver 104 may further comprise a receiver unit 172, which may also be referred to as the receiver 172. The receiver unit 172 is connected to the two transceiver terminals 176, 178. The receiver unit 172 may receive a signal, also referred to as a receive signal, representing receive data, in particular an Ethernet packet, via the transceiver terminals 176, 178. The receiver unit 172 may be coupled to the controller 154 via a receive data, RX, signal connection 166. The receiver unit 172 may be configured to transmit the receive data, in particular the received Ethernet packet, to the controller 154 via the RX signal connection 166. The transceiver 104 may further comprise a detection unit 174 coupled to the transceiver terminals 176, 178. The detection unit 174 may be configured to detect a data transmission over the transceiver terminals 176, 178, and upon positive detection, transmit a detection signal to the controller 154 over the further signal connection 168, the detection signal indicating positive detection of a data transmission.

The network node 142 may comprise a first voltage supply terminal 116 and the second voltage supply terminal 118. The first voltage supply terminal 116 may supply a first electrical voltage potential to the network node 142, and the second voltage supply terminal 118 may supply a second electrical voltage potential to the network node 142. The first electrical voltage potential may also be referred to as the first supply voltage. The second electrical voltage potential may also be referred to as the second electrical voltage supply.

In an example, the controller 154 comprises a physical medium attachment (PMA) unit 160, a physical coding sublayer (PCS) unit 158, and a physical layer collision avoidance (PLCA) unit 156. The controller 154, the PMA unit 160, the PCS unit 158, and/or the PLCA unit 156 may be configured according to the 10BaseT1s standard. The PMA unit 160 may be configured to send data over the TX signal connection 164, to receive data over the RX signal connection 166, to perform collision detection, to perform clock recovery, and/or to perform delay compensation. The PCS unit 158 may be configured to encode data bits for transmission over the PMA unit 160 and/or to decode data bits from a signal received over the PMA unit 160. The PLCA unit 156 may be configured to schedule the time slot for which transmit data packets are transmitted such that only one network node is occupying the bus. PLCA unit 158 may be configured to receive and/or transmit data over interface 148. The PLCA unit 158 may provide effective data throughput at the interface 148.

In the example network node 142 of Figure 2, the capacitors 120, 122 are integrated between the common mode choke 150 and the transceiver 104 in the first and second signal connections 180, 182. The arrangement of the common mode choke 150 and the capacitors 120, 122 may also be swapped. In an example, the common mode choke 150 is arranged "to the left" of the two capacitors 120, 122. The common mode choke 150 may be integrated between the transceiver 104 and the capacitors 120, 122 in the first and second signal connections 180, 182.

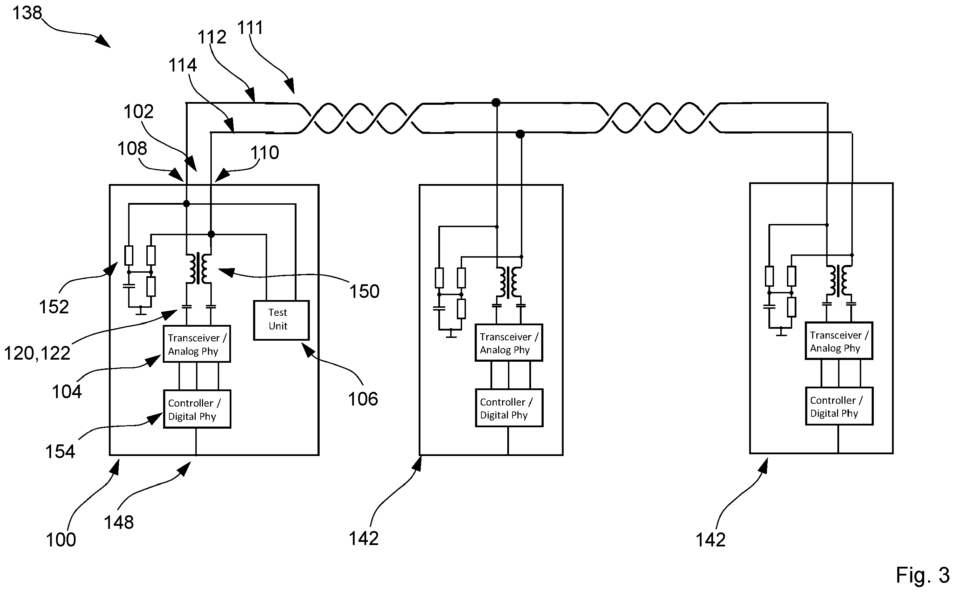

Figure 3 schematically illustrates an example of another embodiment of a system 138. The system 138 of Figure 3 is similar to the system 138 of Figure 1, except that the network node 100 located on the left differs from the two other network nodes 142 located centrally and on the right. The network node 100 may be referred to as the primary network node 100. Each of the further network nodes 142 may be referred to as secondary network node 142. For the system 138, and in particular for the network nodes 142, reference is made to the preceding explanations, preferred features, technical effects and advantages in an analogous manner as previously explained for the system 138 and/or the network node 142.

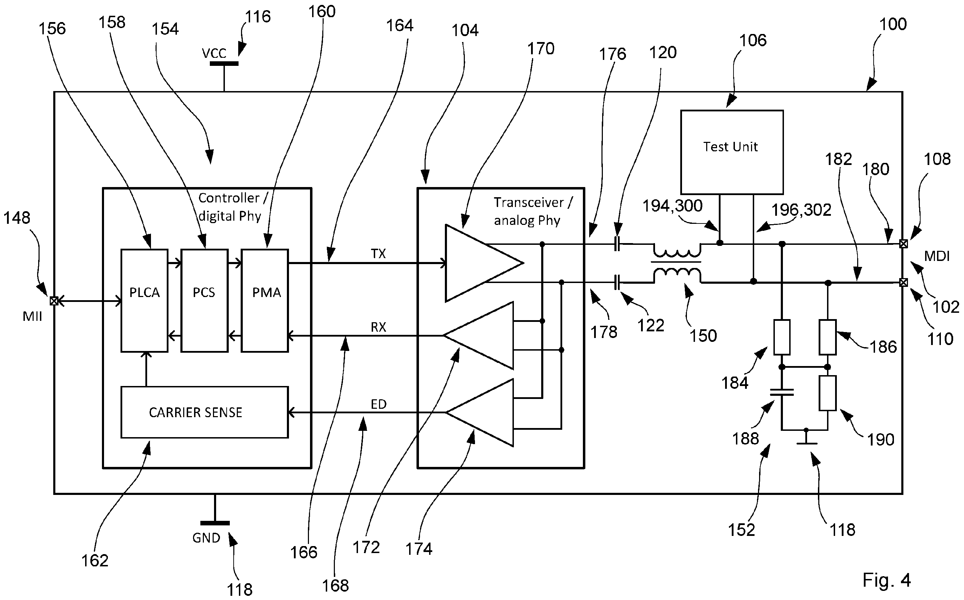

Figure 4 schematically illustrates an embodiment of the network node 100. In an example, the network node 100 may form a primary network node 100. The network node 100 comprises an interface 102, referred to as a network interface 102. The network interface 102 comprises a first terminal 108 and a second terminal 110. The first terminal 108 may be referred to as the first network terminal 108 and the second terminal 110 may be referred to as the second network terminal 110. The network interface 102 is for connection to a two-wire network cable 111. The two-wire network cable 111 may comprise a first wire 112 and a second wire 114 that are twisted at least in sections. The first wire 112 may be referred to as the first network line 112 and the second wire 114 may be referred to as the second network wire 114. The first network terminal 108 may be configured to be electrically connected to the first network line 112. The second network terminal 110 may be configured to be electrically connected to the second network line 114.

The network node 100 further comprises a transceiver 104. The transceiver 104 may also be referred to and/or configured as an analog transceiver 104 or an analog phy. The transceiver 104 is coupled to the two network terminals 108, 110. Further, the transceiver 104 is configured to generate a transmit signal at the network interface 102 (or at the two network terminals 108, 110), wherein the transmit signal represents an Ethernet packet.

It is noted that the network node 100 may also be configured independently of the system 138. The network node 100 may be configured as a device. The network node 100 may be configured individually or may be integrated into another, larger device. For the network node 100, reference is made to the advantageous explanations, preferred features, technical effects and advantages in an analogous manner as previously explained for the network node 142.

The network node 100 further comprises a test unit 106. The test unit 106 is shown schematically in Figure 4. The test unit 106 is galvanically coupled to the network terminals 108, 110. The galvanic coupling may be configured as a galvanic electrical connection. Preferably, the galvanic coupling does not comprise electrically insulating elements, such as capacitors, optocouplers, and/or transformers. In an example, the galvanic coupling may be formed by an uninterrupted wire or other metallic uninterrupted wire or an interrupted conducting line. The uninterrupted conductive line may be configured to permanently conduct a direct current.

The test unit 106 is configured to detect a short circuit between the network terminals 108, 110, and/or to detect a short circuit between the network lines 112, 114, and/or to detect a short circuit between one of the network lines 112, 114 and a supply voltage 116, 118 of the network node 100, and/or to detect a short circuit between one of the network terminals 108, 110 and a supply voltage 116, 118 of the network node 100, and/or to detect a break in at least one of the network lines 112, 114.

A short circuit may refer to a connection (not intended) that has a very low electrical resistance. A short circuit may be classified into two types, namely the hard short circuit and the soft short circuit. The soft short circuit may also be referred to as weak short circuit. A hard short circuit may refer to an (unintended) connection that comprises an electrical resistance that is less than a first threshold resistance, which is, for example, 10 ohm, 5 ohm, or 2 ohm. A soft short circuit may refer to a (not intended) connection comprising an electrical resistance greater than the first threshold resistance and less than a second threshold resistance, the second threshold resistance is, for example, 500 ohm, 400 ohm, 300 ohm, 200 ohm, or 100 ohm.

The test unit 106 may be configured to detect as a short circuit the soft short circuit and/or the hard short circuit. Of particular interest is the use of the test unit 106 to detect, as a short circuit, a soft short circuit. If a short circuit is referred to hereinafter (and above), in an example, the short circuit may be the soft short circuit.

A break may refer to a defective section (not intended) of a connection that has a very high electrical resistance. A break may be classified into two types, namely the hard break and the soft break. The soft break may also be referred to as an "open" section or an "open" connection. A hard break may refer to an (unintended) defective section of a connection that comprises an electrical resistance that is higher than a third threshold resistance, which is, for example, 10 mega ohm, 5 mega ohm, or 2 mega ohm. A soft break may refer to a (not intended) defective session of a connection comprising an electrical resistance that is higher than a fourth threshold resistance, which is, for example, 10 ohm, 5 ohm, or 2 ohm and less than a fifth threshold resistance, which is is, for example, 500 ohm, 400 ohm, 300 ohm, 200 ohm, or 100 ohm.

The test unit 106 may be configured to detect as a break the soft break and/or the hard break. Of particular interest is the use of the test unit 106 to detect, as a break, a soft break. If a break is referred to hereinafter (and above), in an example, the break may be the soft break.

Voltage supply of network node may depend and/or may be directly or indirectly supplied by another supply voltage of a higher level unit. The network node may be part of the higher level system. Further, a short between a network line and the supply voltage of the higher level unit corresponds - due the dependency of the voltage supply of the network node to the voltage supply of the higher level system - to a short between the same network line and the supply voltage of the higher level system. As a result, a detection of a short between the voltage supply of the network node and a network line may - in an example - cover also a short between the network line and the voltage supply of the higher level system. The higher level system may be an ECU or other communication or control device.

If reference is made to a structural fault, the structural fault may mean at least one of the following:
- a short circuit between the network terminals 108, 110, and/or
- a short circuit between the network lines 112, 114, and/or
- a short circuit between one of the network lines 112, 114 and a supply voltage 116, 118 of the network node 100, and/or
- a short circuit between one of the network terminals 108, 110 and a supply voltage 116, 118 of the network node 100, and/or
- an interruption in at least one of the network lines 112, 114.

In an example, the structural fault may be one of the aforementioned short circuits. In another example, the structural fault may be an interruption. The test unit 106 may be configured to detect at least one of the structural faults.

If a structural fault occurs, the structural fault causes a change in a first electrical voltage at the first network terminal 108 and/or a change in a second electrical voltage at the second network terminal 110. The test unit 106 is galvanically coupled to the network terminals 108, 110. In terms of the respective galvanic coupling, reference is made to the previous respective explanations. In an example, the test unit 106 is configured to measure the first electrical voltage and/or the second electrical voltage. The first electrical voltage may also be referred to as the first voltage. The second electrical voltage may also be referred to as the second voltage. A difference between the first voltage and the second voltage may form a differential voltage, also referred to as a differential terminal voltage. The differential terminal voltage is therefore applied between the first network terminal 108 and the second network terminal 110. The test unit 106 may be configured to measure the differential terminal voltage.

In an example, if a short circuit occurs between the first network terminal 108 and the first voltage supply terminal 116 (to which the first supply voltage is applied), then the first voltage at the first network terminal 108 is pulled to the first supply voltage. In other words, in this example, there may be a short circuit between the first network terminal 108 and the first supply voltage. In an example, due to the fact that the test unit 106 is galvanically coupled to the first network terminal 108, the test unit 106 may detect if the first voltage at the first network terminal 108 is pulled to the first supply voltage and/or if the short circuit is present between the first network terminal 108 and the first supply voltage. Similarly, in an example, the test unit 106 may be configured to detect the further structural faults.

The network node including the transceiver 104 and the test unit 106 allow for a cost-effective and reliable harness defect detection for multi-drop bus systems like 10BASE-T1S. In an example, just one network node 100 of several network nodes 100, 142 may comprise the test unit 106, but still, the primary network node 100 may be able to detect structural faults. The other network nodes 142, which may not comprise the test unit 106, do not negatively influence the function of the test unit 106, since their transceivers 104 are preferably galvanically isolated coupled to the network terminals of the respective network nodes 142. Since the test unit 106 is not capacitive coupled to the network terminals 108, 110 of the primary network node 100, the test unit 106 allows for an accurate and robust detection of a structural fault. This also enables a simple and cost-effective implementation of the harness defect detection functionality.

In an example, the test unit 106 is configured separately from the transceiver 104. In the example shown in Figure 4, the transceiver 104 and the test unit 106 are schematically shown as separate entities. The first signal connection 180 extends from the first transceiver terminal 176 of the transceiver 104 to the first network terminal 108 of the network node 100, and the second signal connection 182 extends from the second transceiver terminal 178 of the transceiver 104 to the second network terminal 110. In an example, the first capacitance 120 is integrated into the first signal connection 180. The integration of the first capacitance 120 causes the first transceiver terminal 176 to be galvanically isolated and/or only capacitively coupled to the first network terminal 108. Further, the second capacitance 122 may be integrated into the second signal connection 182. The integration of the second capacitance 122 causes the second transceiver terminal 178 to be galvanically isolated and/or only capacitively coupled to the second network terminal 110. As an effect, the transceiver 104 may be galvanically isolated and/or only capacitively coupled to the network interface 102 and/or to the network terminals 108, 110.

Figure 3 schematically illustrates an embodiment of a system 138 wherein the primary network node 100 comprises the transceiver 104 that is galvanically isolated and/or only capacitively coupled to its network terminals 108, 110, and wherein each secondary network node 142 comprises the transceiver 104 that is galvanically isolated and/or only capacitively coupled to its network terminals 108, 110. Each network node 100, 142 of the system 138 is coupled in parallel with the first and second network lines 112, 114. As an effect, the transceivers 104 of the network nodes 100, 142 are galvanically isolated and/or only capacitively coupled to the network lines 112, 114. Nevertheless, each transceiver 104 may cause a differential voltage across the respective associated first and second transceiver terminals 176, 178 such that a corresponding differential voltage is caused between the first and second network lines 112, 114. Due to galvanic isolation and/or capacitive coupling, the transceivers 104 are unable to cause a predefined common mode voltage on the first and second network lines 112, 114. In this context, a common mode voltage on the first and second network lines 112, 114 may be understood in an example to be a voltage (or voltage component) that is simultaneously present with the same phase to both the first network line 112 and the second network line 114.

The fact provided in connection with the previous examples that none of the transceivers 104 can cause a predefined common mode voltage to be applied to the associated transceiver terminals 176, 178 or to the network lines 112, 114 provides an advantage to the test unit 106. The test unit 106 of the primary network node 100 is galvanically coupled to the network terminals 108, 110 of the primary network node 100. In this regard, reference is again made to the embodiment of the primary network node 100 shown schematically in Figure 4.

In an example, the test unit 106 is connected to the first signal connection 180 via a signal connection 194. The connection between the signal connection 194 and the first signal connection 180 is configured at a location on the signal connection 180, from which location the first signal connection 180 provides a galvanic connection to the first network terminal 108. As an effect, the signal connection 194 and the section between the aforementioned location of the first signal connection 180 and the first network terminal 108 provides a galvanic connection between the test unit 106 and the first network terminal 108, the galvanic connection being referred to as the first test connection 300. Preferably, the aforementioned section does not include any insulating components, such as a capacitor or an optocoupler.

In an example, the test unit 106 is connected to the second signal connection 182 via a signal connection 196. The connection between the signal connection 196 and the second signal connection 182 may be configured a location of the second signal connection 182, from which location the second signal connection provides a galvanic connection to the second network terminal 110. As an effect, the signal connection 196 and the section between the aforementioned location of the second signal connection 182 and the second network terminal provides a galvanic connection between the test unit 106 and the second network terminal 110, the galvanic connection being referred to as the second test connection 302. Preferably, the aforementioned section does not include any insulating components, such as a capacitor or an optocoupler.

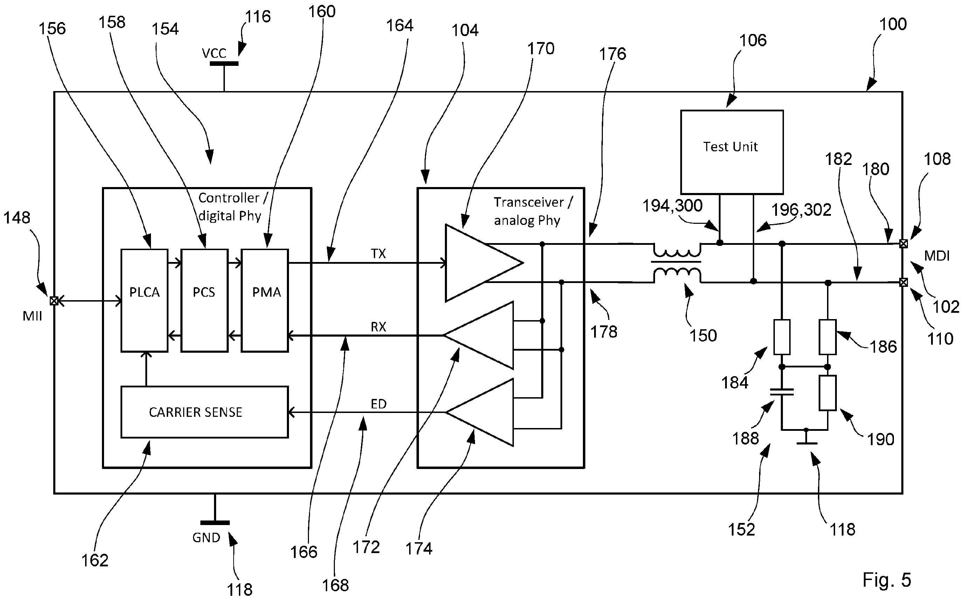

In Figure 5, an example of the network node 100 is shown schematically. For the network node 100, reference is made to the advantageous explanations, preferred features, technical effects and advantages in an analogous manner as they have been explained for the network node 100 of Figure 4.

The network node 100 of Figure 5 differs from the network node 100 of Figure 4 in that the network node 100 of Figure 5 does not comprise the first capacitor 120 and further does not comprise the second capacitor 122. As one effect, the transceiver 104 may be galvanically electrically coupled to the network interface 102 and/or to the first and second network terminals 108, 110. In an example, the first and second signal connections 180, 182 may extend from the network terminals 108, 102 to the transceiver terminals 176, 178, and the common mode choke 150 may be integrated into the two signal connections 180, 182. Removing the first and second capacitors 120, 122 may cause high voltages to be applied to the transceiver 104. It is therefore advantageous if the transceiver 104 is robust against high voltages.

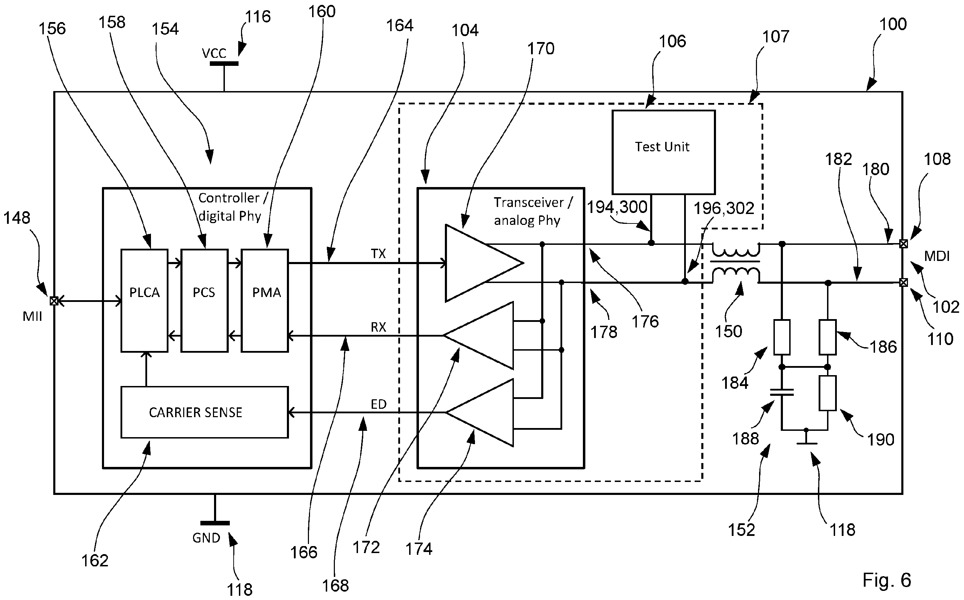

Figure 6 schematically illustrates an example of a network node 100. For the network node 100, reference is made to the advantageous explanations, preferred features, technical effects and advantages in an analogous manner as they have been explained for the network node of Figures 4 and 5.

In an example, the network node 100 of Figure 6 differs from the network node 100 of Figure 5 in that in the network node 100 of Figure 6, the arrangement of the test unit 106 and the common mode choke 150 are swapped. In an example, the test unit 106 may be galvanically electrically coupled in a section to the first and second signal connections 180, 182, said section being between the common mode choke 150 and the transceiver terminals 176, 178. As an effect, the test unit 106 is electrically coupled to the network interface 102 and/or the first and second network terminals 108, 110 via the signal connections 180, 182 and the common mode choke 150.

In an example, the transceiver 104 and the test unit 106 may be configured as separate units of the network node 100. In another example, the transceiver 104 and the test unit 106 may each be configured as a part of a common unit 107. The unit 107 may be referred to as the transceiver-test unit 107. In another example, the test unit 106 may be integrated into the transceiver 104, or vice versa. The common embodiment and/or integration may result in a particularly compact design.

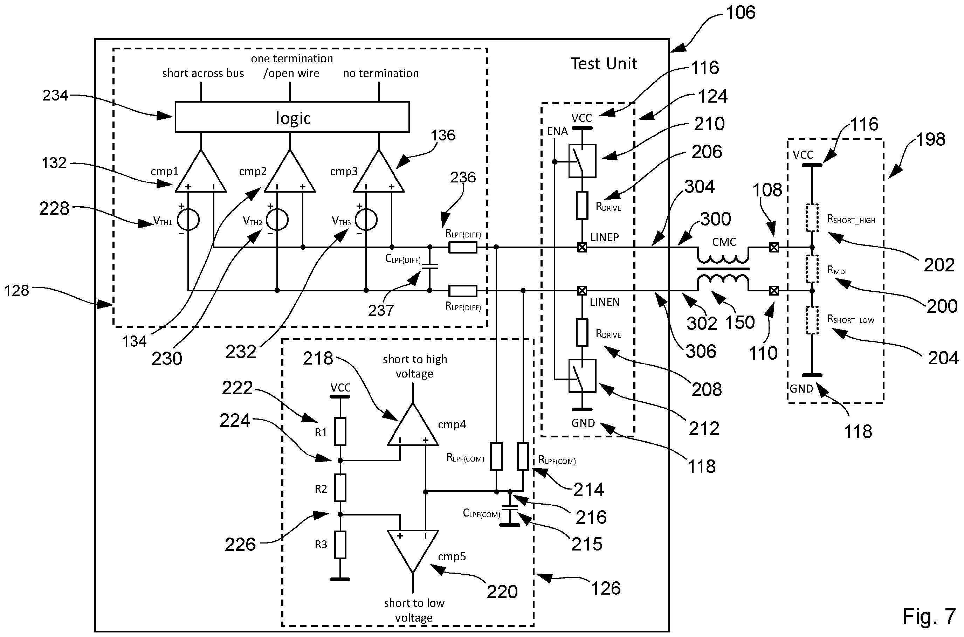

In Figure 7, an embodiment of the test unit 106 is schematically shown. Figure 7 also schematically illustrates selected, individual parts of the primary network node 100. These parts include, for example, a schematic representation of the first network terminal 108 and the second network terminal 110. The test unit 106 is coupled to the first network terminal 108 via the first test connection 300. The first test connection 300 is a galvanically electrically conductive connection. Further, the test unit 106 is coupled to the second network terminal 110 via the second test connection 302. The second test connection 300 is a galvanically electrically conductive connection. In an example, the first and second test connections 300, 302 may include the common mode choke 150, wherein a first coil of the common mode choke 150 is integrated in the first test connection 300, and wherein a second coil of the common mode choke 150 is integrated in the second test connection 302.

The test unit 106 may comprise a driver unit 124. The driver unit 124 may be galvanically coupled to network terminals 108, 110 via the first and second test connections 300, 302. The driver unit 124 may be configured to generate a reference common mode voltage at the two network terminals 108, 110. The reference common mode voltage may be a predefined common mode voltage. Additionally or alternatively, the driver unit 124 may be configured to generate a reference differential voltage at the two network terminals 108, 110. The reference differential voltage may be a predefined differential voltage.

In an example, the test unit 106 comprises a signal connection 304, referred to as the first terminal connection 304. Further, the test unit 106 may comprise a second signal connection 306, referred to as the second terminal connection 306. The first terminal connection 304 may extend from the first test connection 300 to the driver unit 124. The second terminal connection 306 may extend from the second test connection 302 to the driver unit 124. The first terminal connection 304 and the first test connection 300 may be integrally configured. The second terminal connection 306 and the second test connection 302 may be integrally configured.

The driver unit 124 may comprise a first circuit strand comprising a first switch 210, also referred to as a first driver switch 210, and an impedance 206, also referred to as a first driver impedance 206. The first circuit strand may extend between the first terminal connection 304 and the first voltage supply terminal 116. The first voltage supply terminal 116 may receive the first supply voltage of the network node 104.

The driver unit 124 may further comprise a second circuit strand comprising a second switch 212, also referred to as a second driver switch 212, and an impedance 208, also referred to as a second driver impedance 208. The second circuit strand may extend between the second terminal connection 306 and the second voltage supply terminal 118. The second voltage supply terminal 118 may receive the second supply voltage of the network node 104.

In an example, the driver unit 124 may change between an enabled state and a disabled state. In the enabled state of the driver unit 124, both driver switches 210, 212 are closed. In the deactivated state, both driver switches 210, 212 of the driver unit 124 are open. If the driver unit 124 is in the active state, a first reference voltage is generated at the first terminal connection 304 and a second reference voltage is generated at the second terminal connection 306. Each of the first and second reference voltage may be a DC voltage, where the second reference voltage is preferably smaller than the first reference voltage. As an effect, when the driver unit 124 is in the active state, a reference differential voltage and/or reference common mode voltage is generated at the first and second terminal connections 304, 306. Due to the first and second test connections 300, 302, the reference differential voltage and/or reference common mode voltage is also generated at the first and second network terminals 108, 110. Furthermore, the test unit 106 may be configured to detect a structural fault if the driver unit 124 is in the active state.

In an example, the primary network node 100 comprises a termination network 152. An example of the termination network 152 is shown schematically in each of Figures 4 to 6. In particular, the first resistor 184 and the second resistor 186 of the termination network 152 may cause a voltage to drop across the two resistors 184, 186 if the driver unit 124 is in the active state. As an effect, the first reference voltage (at the first network terminal 108) differs from the second reference voltage (at the second network terminal 110). Provided there is no structural fault and if in a system 138, such as schematically shown in example in Figure 3, a plurality of network nodes 100, 142 are connected in parallel via the first and second network lines 112, 114, then there continues to be a non-zero impedance between the first network terminal 108 of the primary network node 100 and the second network terminal 110 of the primary network node 100. As an effect, provided there is no structural fault, when the driver unit 124 is in the active state, the driver unit 124 can generate the desired reference differential voltage and/or the desired reference common mode voltage at the network terminals 108, 110 of the primary network node 100. Because the transceiver 104 of the primary network node 100 is only capacitively coupled to the network terminals 108, 110 of the primary network node 100 and because the transceiver 104 of each secondary network node 142 is only capacitively coupled to the network terminals 108, 110 of the respective secondary network node 142, all transceivers 104 do not prevent the driver unit 124 from generating the desired reference differential voltage and/or the desired reference common mode voltage at the network terminals 108, 110 of the primary network node 100 and/or at the network lines 112, 114 when in the active state.

In Figure 7, an area 198 is marked where possible paths for a short circuit are schematically shown. The schematically indicated impedances 200, 202, 204 may each alternatively represent a short circuit. Impedance 200 may also be referred to as first short circuit resistor 200. Impedance 202 may also be referred to as second short circuit resistor 202. Impedance 204 may also be referred to as third short circuit resistor 204. In an example, each shorting circuit resistor 200, 202, 204 is less than 10 ohm, less than 5 ohm, or less than 2 ohm.

It should be noted that the first short-circuit resistor 200 arises as a substitute only if a short circuit occurs between the two network terminals 108, 110 of the primary network node 100 or if a short circuit occurs between the two network lines 112, 114. In an example, a potential short circuit between the network terminals 108, 110 of the primary network node 100 and/or a potential short circuit between the network lines 112, 114 may be represented via the first short circuit resistor 200.

It should be noted that the second short-circuit resistor 202 arises as a substitute only if a short circuit occurs between the first network line 112 and the first voltage supply terminal 116, or if a short circuit occurs between the first network terminal 108 of the primary network node 100 and the first voltage supply terminal 116. In an example, a potential short circuit between the first network terminal 108 of the primary network node 100 and the first supply voltage at the first voltage supply terminal 116 may be represented via the second short circuit resistor 202. In an example, a potential short circuit between the first network line 112 and the first supply voltage at the first voltage supply terminal 116 may be represented via the second short circuit resistor 202.

It should be noted that the third short circuit resistor 204 arises as a substitute only if a short circuit occurs between the second network line 114 and the second voltage supply terminal 118, or if a short circuit occurs between the second network terminal 110 of the primary network node 100 and the second voltage supply terminal 118. In an example, a potential short circuit between the second network terminal 110 of the primary network node 100 and the second supply voltage at the second voltage supply terminal 118 may be represented via the third short circuit resistor 204. In an example, a potential short circuit between the second network line 114 and the second supply voltage at the second voltage supply terminal 118 may be represented via the third short circuit resistor 204.

Previously, it was explained that the driver unit 124 may be enabled to generate a predefined reference differential voltage and/or reference common mode voltage at the network terminals 108, 110 of the primary network node 100. In fact, the driver unit 124 generates the reference differential voltage and/or reference common mode voltage at the network terminals 108, 110 if there is no structural fault. However, if a short circuit occurs between the first network terminal 108 of the primary network node 100 and the first voltage supply terminal 116 as a structural fault, the actual common mode voltage at the network terminals 108, 110, even if the driver unit 124 is in the active state, is pulled from the reference common mode voltage to a different, higher voltage potential such that the actual common mode voltage is greater than the reference common mode voltage. An analogous effect occurs if, as a structural fault, a short circuit occurs between the first network line 112 and the first voltage supply terminal 116. In another case, if a short circuit between the second network terminal 110 of the primary network node 100 and the second voltage supply terminal 118 occurs as a structural fault rather than the aforementioned short circuit, the actual common mode voltage at the network terminals 108, 110 - even if the driver unit is in the active state - is pulled from the reference common mode voltage to a different, smaller voltage potential, so that the actual common mode voltage is smaller than the reference common mode voltage. An analogous effect occurs if a short circuit occurs between the second network line 114 and the second voltage supply terminal 118 as a structural fault.

In an example, the test unit 106 comprises a sensor unit 126. The sensor unit 126 may also be referred to as the first sensor unit 126. The first sensor unit 126 is galvanically coupled to the two network terminals 108, 110 of the primary network node 100. In Figure 7, an embodiment of the first sensor unit 126 is schematically shown. The first sensor unit 126 may be configured to measure a common mode voltage actually present at the network terminals 108, 110. The sensed common mode voltage may also be referred to as the actual common mode voltage. As previously discussed in consideration of the possible structural faults, the actual common mode voltage may differ from the reference common mode voltage. If the actual common mode voltage is greater than the reference common mode voltage, this relationship indicates a short circuit through by the second short circuit resistor 202. If the actual common mode voltage is less than the reference common mode voltage, this relationship indicates a short circuit through the third shorting resistor 204.

In an example, the sensor unit 126 is configured to detect a short circuit between the first supply terminal 116 and either the first network terminal 108 of the primary network node 100 or the first network line 112 based on a voltage difference between the reference common mode voltage and the (measured) actual common mode voltage. In an example, the sensor unit 126 may positively detect the aforementioned short circuit if the voltage difference is negative and the magnitude of the voltage difference is greater than a predefined threshold.

In an example, the sensor unit 126 may (further) be configured to detect a (further) short circuit between the second supply terminal 118 and either the second network terminal 110 of the primary network node 100 or the second network line 114 based on a voltage difference between the reference common mode voltage and the (measured) actual common mode voltage. In an example, the sensor unit 126 may positively detect in the aforementioned short circuit if the voltage difference is positive and the magnitude of the voltage difference is greater than a predefined threshold.

In an example, the sensor unit 126 may comprise a first circuit 214. The first circuit 214 may be galvanically coupled to the two network terminals 108, 110 of the primary network node 100. The first circuit 214 may be configured to sense and/or provide the actual common mode voltage at a sensing point 216. The sensor unit 126 may also comprise a capacitor 215, which is preferably connected between the sensing point 216 and the second voltage supply terminal 118. The combination of the first circuit 214 and the capacitor 215 may form a low pass filter being effective at the sensing point 216. As an effect, high frequency components of a signal at the sensing point 216 can be suppressed, such that preferably just a DC component is left at the signaling point 216. As a further effect, the combination also supports the EMC robustness of the sensor unit 126. In an example, the sensor unit 126 may comprise a second voltage divider circuit 222 extending between the first voltage supply terminal 116 and the second voltage supply terminal 118. The second voltage divider circuit 222 may generate a fourth threshold voltage 224 and a fifth threshold voltage 226. Further, the sensor unit 126 may comprise a fourth comparator 218 and a fifth comparator 220. The fourth and fifth comparators 218, 220 may each be coupled to the sensing point 216 such that the fourth and fifth comparators 218, 220 are each supplied with the actual common mode voltage. The fourth comparator 218 is also supplied with the fourth threshold voltage 224. The fifth comparator is also supplied with the fifth threshold voltage 226. The fourth threshold voltage is greater than the reference common mode voltage. The fifth threshold voltage 226 is less than the reference common mode voltage.. If the actual common mode voltage at the sensing point 216 is greater than the fourth threshold voltage 224, the comparator 218 triggers, wherein the triggering of the comparator 218 represents the detection of a short circuit between the first voltage supply terminal 116 and either the first network terminal 108 of the primary network node 100 or the first network line 112. If the actual common mode voltage at the sensing point 216 is less than the fifth threshold voltage 226, then the comparator 220 triggers, wherein the triggering of the comparator 220 represents a detection a short circuit between the second voltage supply terminal 118 and either the second network terminal 110 of the primary network node 100 or the second network line 114.

Against this background, in an example, the test unit 106, and preferably the first sensor unit 126, may be configured to detect a short circuit referred to as a second short circuit between one of the network lines 112, 114 and a supply voltage (or one of the voltage terminals 116, 118) of the primary network node 100 based on a voltage difference between the reference common mode voltage and the (detected) actual common mode voltage. The voltage difference may be detected while the driver unit 124 is activated.

In an example, the test unit 106 comprises a sensor unit 128 referred to as the second sensor unit 128. The second sensor unit 128 is galvanically coupled to both network terminals 108, 110 of the primary network node 106. In one example, the second sensor unit 128 may be galvanically coupled to the two network terminals 108, 110 via the first and second terminal connections 304, 306.

In an example, a second low pass circuit 236 is integrated into the first and second terminal connections 304, 306. The second low pass circuit 236 may comprise two impedances and a capacitor 237. A first impedance of the second low pass circuit 236 may be integrated into the first terminal connection 304 and the other, second impedance of the low pass circuit 236 may be integrated into the second terminal connection 306. The capacitor 237 of the second low-pass circuit 236 may be coupled between the first terminal connection 304 and the second terminal connection 306. The capacitor 237 of the second low-pass filter 236 may be arranged to provide a low pass filtered signal to the second sensor unit 128. The second low-pass circuit 236 may be integrated into a portion of the first and second terminal connections 304, 306 such that the second sensor unit 128 alone follows the second low-pass circuit 236 along the first and second terminal connections 304, 306. In particular, the second sensor unit 128 alone may benefit from the second low-pass circuit 236. In another example, the second low-pass circuit 236 may form part of the second sensor unit 128. As an effect, high frequency components of voltage signals from the first and second network terminals 108, 110 may be suppressed before reaching the second sensor unit 128. As a further effect, the second low pass filter circuit 236 may also support the EMC robustness of the second sensor unit 128.

In an example, the second sensor unit 128 is configured to directly or indirectly measure an impedance, referred to as a termination impedance, between the first network terminal 108 and the second network terminal 110 of the primary network node 100. As has been previously explained, the primary network node 100 may comprise a termination network 152, wherein the series connection of the first resistor 184 and the second resistor 186 may form the termination impedance. The first resistor 184 and the second resistor 186 may each comprise an impedance of 50 ohms. If the primary network node 100 is considered alone, the termination impedance may be formed by connecting the two resistors 184, 186 in series. In this case, the termination impedance may be 100 ohms, for example. If the primary network node 100 is a part of a system 138, as shown schematically in Figure 3 for example, the termination impedance between the two network terminals 108, 110 of the primary network node 100 may be determined by a parallel connection of the termination networks 152 of the plurality of network nodes 100, 142. In this example, the termination impedance may be 50 ohms.

As previously explained, the test unit 106 may comprise a driver unit 124 configured to generate a reference differential voltage and/or reference common mode voltage at the network terminals 108, 110 of the primary network node 100. Due to the termination impedance between the two network terminals 108, 110 of the primary network node 100 and also due to the reference differential voltage and/or reference common mode voltage, a differential voltage referred to as the differential terminal voltage drops across the termination impedance. The magnitude of the differential terminal voltage may be proportional to the magnitude of the termination impedance. Against this background, the termination impedance can be measured at least indirectly via the differential terminal voltage. In an example, the second sensor unit 128 may be configured to indirectly detect the termination impedance by measuring of the differential terminal voltage. Alternatively or additionally, the second sensor unit 128 may be configured to directly detect the termination impedance.

Figure 7 schematically illustrates an embodiment of the test unit 106 and/or an embodiment of the second sensor unit 128. The second sensor unit 128 may comprise a plurality of comparators 132, 134, 136 and a plurality of reference voltage sources 228, 230, 232 each having an associated reference voltage.

Against this background, the second sensor unit 128 may comprise the first comparator 132 and the first reference voltage (or the first reference voltage source 228). In an example, the first terminal connection 304 is coupled to the first comparator 132. Further, the second terminal connection 306 may be coupled to the first comparator 132, wherein the first reference voltage source 228 is integrated into a section of the second terminal connection 306 leading only to the first comparator 132. In an example, the first comparator 132 is configured to trigger if the differential terminal voltage is less than the first reference voltage. At least in this case, the second sensor unit 128 senses the differential terminal voltage by means of the first comparator 132 and the first reference voltage source 228. The differential terminal voltage is proportional to the actual termination impedance. By measuring the differential voltage, the sensor unit 128 may also measure the termination impedance, at least indirectly. The first reference voltage may be proportional to a first reference impedance. The first reference impedance may represent a lower threshold for an allowable value of the termination impedance. The first reference impedance may be predefined. If the termination impedance is less than the first reference impedance, then this relationship implies a short circuit between the network terminals 108, 110 of the primary network node 100 or a short circuit between the network lines 112, 114. In an example, the second sensor unit 128 may be configured to detect a short circuit between the network terminals 108, 110 of the primary network node 100 or a short circuit between the network lines 112, 114 by triggering the first comparator 132. The short circuit between the network terminals 108, 110 or between the network lines 112, 114 may be referred to as a second short circuit. In an example, the first reference impedance may comprise a value between 25 ohms and 45 ohms, such as 30 ohms or 40 ohms. The first reference voltage may be predefined accordingly.

In an example, the second sensor unit 128 may comprise the second comparator 134 and the second reference voltage (or a second reference voltage source 230). The first terminal connection 304 may be coupled to the second comparator 134. Further, the second terminal connection 306 may be coupled to the second comparator 134, wherein the second reference voltage source 230 is integrated into a section of the second terminal connection 306 leading only to the second comparator 134. In an example, the second comparator 134 is configured such that the second comparator 134 triggers if the differential terminal voltage is greater than the second reference voltage. At least in this case, the second sensor unit 128 senses the differential terminal voltage through the second comparator 134 and the second reference voltage source 230. The second reference voltage may be proportional to a second reference impedance. The second reference impedance may represent an upper threshold for an allowable value of the termination impedance. The second reference impedance may be predefined. In an example, the second reference impedance may comprise a value between 60 ohms and 80 ohms, such as 70 ohms or 75 ohms. If the termination impedance is greater than the second reference impedance, then this relationship implies either a break in one of the network lines 112, 114 or a fault in one of the termination networks 152. A fault in a termination network may also be referred to as a termination fault, a termination fault in the network lines, or a termination fault in the network connections.

In an example, the second sensor unit 128 may comprise the third comparator 136 and the third reference voltage (or a third reference voltage source 232). The first terminal connection 304 may be coupled to the third comparator 136. Further, the second terminal connection 306 may be coupled to the third comparator 136, wherein the third reference voltage source 232 is integrated into a section of the second terminal connection 306 leading only to the third comparator 136. In an example, the third comparator 136 may be configured such that the third comparator 136 triggers if the differential terminal voltage is greater than the third reference voltage. At least in this case, the second sensor unit 128 senses the differential terminal voltage through the third comparator 134 and the third reference voltage source 232. The third reference voltage may be proportional to a third reference impedance. The third reference impedance may represent a threshold value for a value of the termination impedance used to distinguish between a potential break of one of the network lines and a potential termination fault. The third reference impedance may be predefined. In an example, the third reference impedance may comprise a value between 180 ohms and 350 ohms, such as being 200 ohms, 250 ohms, or 290 ohms. If the termination impedance is greater than the third reference impedance, then this relationship implies a termination fault. In an example, the second sensor unit 128 may be configured such that the second sensor unit 128 detects a termination fault by triggering the third comparator 136.

If the termination impedance is greater than the second reference impedance and less than the third reference impedance, then this relationship implies a break in one of the network lines 112, 114. In an example, the second sensor unit 128 comprises an evaluation unit 234 coupled to at least the output of the second comparator 134 and the output of the third comparator 136. In an example, the sensor unit 128 may be configured, preferably via the evaluation unit 234, such that the second sensor unit 128 is configured to detect a break in one of the network lines 112, 114 by triggering the second comparator 134 if the third comparator 136 is not triggering at the same time. The break in one of the network lines 112, 114 may be referred to as the first break.

If the termination impedance is greater than the first reference impedance, and if the termination impedance is at the same time less than the second reference impedance, then this relationship implies that no structural fault exists. In an example, the second sensor unit 128 may be configured such that the second sensor unit 128 detects that no structural fault exists by not triggering the first comparator 132 and simultaneously not triggering the second comparator 134.

In an example, the second sensor unit 128 comprises the evaluation unit 234, wherein the outputs of the comparators 132, 134, 136 are coupled to the evaluation unit 234. At the outputs, the comparators 132, 134, 136 may output whether they have triggered (value of one, for example) or have not triggered (value of zero, for example).

If the termination impedance is less than the first reference impedance, then it is also true that the differential terminal voltage is less than the first reference voltage. As a result, in this case, the first comparator 132 alone may trigger, while simultaneously the second comparator 134 and the third comparator 136 do not trigger. The evaluation unit 234 may be configured, in response to a triggering of the first comparator 132 and a simultaneous non-tripping of the second and third comparators 134, 136, to detect a short circuit between the two network lines 112, 114 and/or between the two network terminals 108, 110 of the primary network node 100. This short circuit may also be referred to as a first short circuit.

If the termination impedance is greater than the second reference impedance and less than the third reference impedance, then it is also true that the differential terminal voltage is greater than the second reference voltage and less than the third reference voltage. However, the differential terminal voltage is not smaller than the first reference voltage. As a result, in this case only the second comparator 134 triggers, while simultaneously the first comparator 132 and the third comparator 136 do not trigger. The evaluation unit 234 may be configured to detect a break of one of the network lines 112, 114 in response to a triggering of the second comparator 134 and a simultaneous non-triggering of the first and third comparators 134, 136. This break may be referred to as the first break.

If the termination impedance is greater than the third reference impedance (and therefore greater than the second reference impedance), then it is also true that the differential terminal voltage is greater than the third and second reference voltages. However, the differential terminal voltage is not smaller than the first reference voltage. As a result, in this case, the second and third comparators 134, 136 only may trigger, while at the same time the first comparator 132 does not trigger. The evaluation unit 234 may be configured to detect a termination fault in response to a triggering of the second and third comparators 134, 136 and a simultaneous non-triggering of the first comparator 132.

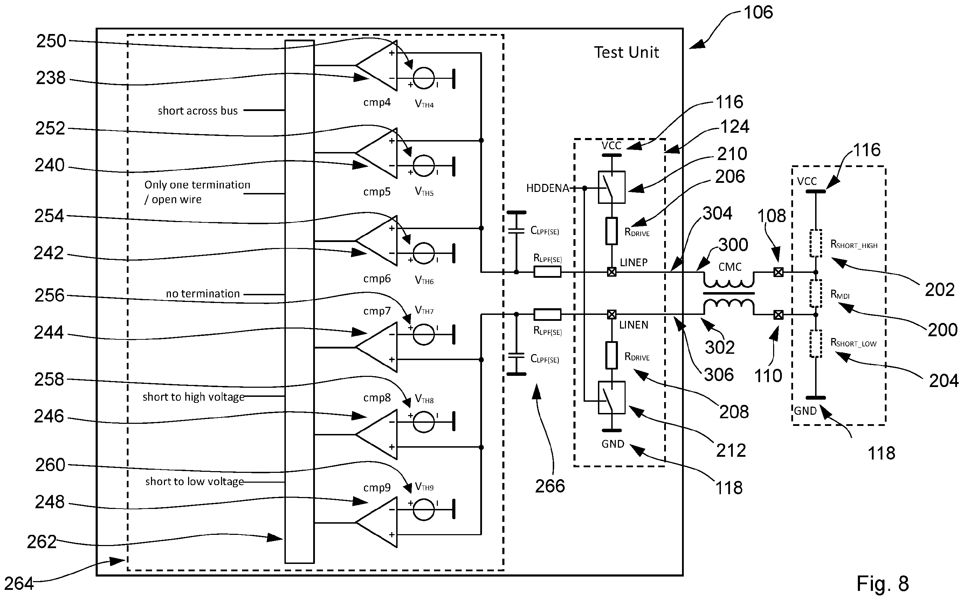

Figure 8 schematically illustrates an embodiment of the test unit 106. For the test unit 106 of Figure 8, reference is made to the preceding explanations, preferred features, technical effects and advantages in an analogous manner as previously discussed for the test unit 106, in particular in connection with Figure 7. Compared to the embodiment of the test unit 106 of Figure 7, the test unit 106 of Figure 8 comprises a third sensor unit 264 instead of the first and second sensor units 126, 128.

The sensor unit 106 preferably comprises the driver units 124. The test unit 106 may also comprise the first and second terminal connections 304, 306. The first terminal connection 304 may extend from the first test connection 300 to the driver unit 124 and/or through the driver unit 124 to the third sensor unit 264. The second terminal connection 306 may extend from the second test connection 302 to the driver unit 124 and/or via the driver unit 124 to the third sensor unit 264.

With respect to the driver unit 124, reference is also made to the preceding explanations, preferred features, technical effects, and advantages in an analogous manner as previously discussed for the driver unit 124. The driver unit 124 is configured to generate a reference common mode voltage at the network terminals 108, 110.

The third sensor unit 264 is galvanically coupled to at least the first network terminal 108. In an example, the first terminal connection 304 may extend to the third sensor unit 264 such that the third sensor unit 264 is electrically coupled to the first network node 108 via the first terminal connection 304 and the first test connection 300. At least a part of a low-pass filter circuit 266 may be integrated into the first terminal connection 304. However, the integrated part of the filter circuit 266 still support the galvanic connection between the third sensor unit 264 and the first network node 108.

Previously, it was explained that the driver unit 124 may be activated to generate a predefined reference differential voltage and/or reference common mode voltage at the network terminals 108, 110 of the primary network node 100. In fact, the driver unit 124 generates the reference differential voltage and/or reference common mode voltage at the network terminals 108, 110 if there is no structural fault. However, if a short circuit occurs between the first network terminal 108 of the primary network node 100 and the first voltage supply terminal 116 as a structural fault, the actual common mode voltage at the network terminals 108, 110, even if the driver unit 124 is in the active state, is pulled from the reference common mode voltage to a different, higher voltage potential such that the actual common mode voltage is greater than the reference common mode voltage. An analog effect occurs if a short circuit occurs between the first network line 112 and the first voltage supply terminal 116 as a structural fault.

The third sensor unit 264 may be configured to sense a voltage, referred to as the first measurement voltage, at the first network terminal 108. The first measurement voltage sensed by the third sensor unit 264 is the actual, electrical voltage at the first network terminal 108. Provided there is no structural fault and if the driver unit 124 generates the reference voltage at the network terminals 108, 110 of the primary network node 100, it may be assumed that there is an allowable voltage at the first network terminal 108 that is greater than a fourth reference voltage and less than a fifth reference voltage. The fourth reference voltage may represent the smallest allowable value for the voltage at the first network terminal 108. The fifth reference voltage may represent the largest allowable value for the voltage at the first network terminal 108. As previously discussed in consideration of the possible structural faults, the actual measured voltage may differ from the reference voltage at the network terminals 108, 110 if a structural fault is present, while the driver unit 124 is enabled. The structural fault also affects the actual voltage at the first network terminal 108 in an analogous manner. The actual voltage at the first network terminal 108 can be measured via the third sensor unit 264 as a first measurement voltage.

If the driver unit 124 is enabled such that the driver unit 124 actually or attempts to drive the predefined reference voltages at the network terminals 108, 110, the third sensor unit 264 may compare the first measurement voltage to the fourth reference voltage, the fifth reference voltage, and/or a further, sixth reference voltage. Based on the at least one resulting comparison result, the third sensor unit 264 may detect a possible structural fault.

In an example, the third sensor unit 264 may comprise a fourth comparator 238 and a fourth voltage source 250. The fourth voltage source 250 may be configured to generate the fourth reference voltage. Further, the test unit 106 (and/or the third sensor unit 264) may be configured such that the first connection 304 is coupled to the fourth comparator 238. Further, the fourth voltage source 250 may be coupled to the fourth comparator 238. In an example, the fourth comparator 238 is configured such that the fourth comparator 238 triggers if the first measurement voltage is less than the fourth reference voltage. At least in this case, the third sensor unit 264 senses the first measurement voltage through the fourth comparator 238. If the first measurement voltage is less than the fourth reference voltage, then this relationship implies a short circuit between either the network terminals 108, 110 of the primary network node 100 or a short circuit between the network lines 112, 114. The short circuit between the network terminals 108, 110 or the short circuit between the network lines 112, 114 may be referred to as a second short circuit. In an example, the third sensor unit 264 may be configured such that the third sensor unit 264 detects the second short circuit by triggering the fourth comparator 238.

In an example, the third sensor unit 264 may comprise a fifth comparator 240 and a fifth voltage source 252. The fifth voltage source 252 may be configured to generate the fifth reference voltage. Further, the test unit 106 (and/or the third sensor unit 264) may be configured such that the first connector 304 is coupled to the fifth comparator 240. Further, the fifth voltage source 252 may be coupled to the fifth comparator 240. In an example, the fifth comparator 240 is configured such that the fifth comparator 240 triggers if the first measurement voltage is greater than the fifth reference voltage. At least in this case, the third sensor unit 264 senses the first measurement voltage through the fifth comparator 240. If the first measurement voltage is greater than the fifth reference voltage, then this relationship implies a break in one of the network lines 112, 114, particularly a break in the first network line 112. The break may also be referred to as the first break. In an example, the third sensor unit 264 is configured such that the third sensor unit 264 detects the first break by triggering the fifth comparator 240.

In an example, the third sensor unit 264 may comprise a sixth comparator 242 and a sixth voltage source 254. The sixth voltage source 254 may be configured to generate the sixth reference voltage. The sixth reference voltage may be greater than the fifth reference voltage. Further, the test unit 106 (and/or the third sensor unit 264) may be configured such that the first connection 304 is coupled to the sixth comparator 242. Further, the sixth voltage source 264 may be coupled to the sixth comparator 242. In an example, the sixth comparator 242 is configured such that the sixth comparator 242 triggers if the first measurement voltage is greater than the sixth reference voltage. At least in this case, the third sensor unit 264 senses the first measurement voltage through the sixth comparator 242. If the first measurement voltage is greater than the sixth reference voltage, then this relationship implies a termination fault. In an example, the third sensor unit 264 is configured such that the third sensor unit 264 detects the termination fault by triggering the sixth comparator 242.

In an example, the third sensor unit 264 comprises an evaluation unit 262, referred to as the second evaluation unit 262. The outputs of the comparators 238, 240, 242 may be coupled to the second evaluation unit 262. At the outputs, the comparators 238, 240, 242 may output whether they have triggered (value of one, for example) or have not triggered (value of zero, for example).

If the first measurement voltage is less than the fourth reference voltage (of the fourth reference voltage source 250), then it is also true that the first measurement voltage is less than the fifth reference voltage and less than the sixth reference voltage. As a result, in this case, the fourth comparator 238 only may trigger, while simultaneously the fifth comparator 240 and the sixth comparator 242 do not trigger. The evaluation unit 262 may be configured to detect the second short circuit in response to a triggering of the fourth comparator 238 and a simultaneous non-tripping of the fifth and sixth comparators 240, 242. The first short circuit may refer to a short circuit between the two network lines 112, 114 and/or a short circuit between the two network terminals 108, 110 of the primary network node 100.

If the first measurement voltage is greater than the fifth reference voltage (of the fifth reference voltage source 252) and less than the sixth reference voltage (of the sixth reference voltage source 254), then it is also true that the first measurement voltage is greater than the fourth reference voltage (of the fourth reference voltage source 250). As a result, in this case, the fifth comparator 240 may trigger, while at the same time simultaneously the fourth and sixth comparator 238, 242 do not trigger. The evaluation unit 262 may be configured, in response to a triggering of the fifth comparator 240 and a simultaneous non-triggering of the fourth and sixth comparator 238, 242, to detect a break in either of the network lines 112, 114, particularly a break in the first network line 112.

If the first measurement voltage is greater than the sixth reference voltage (of the sixth reference voltage source 254), then it is also true that the first measurement voltage is greater than the fifth reference voltage and greater than the fourth reference voltage. As a result, in this case, the sixth comparator 242 may trigger while the fifth comparator 240 is triggered and the fourth comparator is not triggered. The evaluation unit 262 may be configured to detect the termination fault in response to a triggering of the sixth comparator 242 and a simultaneous triggering of the fifth comparator 240 and non-triggering of the fourth comparator 238.

The third sensor unit 264 may be configured to sense a voltage, referred to as a second measurement voltage, at the second network terminal 110. The second measurement voltage detected by the third sensor unit 264 is the actual, electrical voltage at the second network terminal 110. Provided that there is no structural fault and if the driver unit 124 drives the reference voltage at the network terminals 108, 110 of the primary network node 100, it may be assumed that there is an allowable voltage at the second network terminal 110 that is less than a seventh reference voltage and greater than an eighth reference voltage. The seventh reference voltage may represent the largest allowable value for the voltage at the second network terminal 110. The eighth reference voltage may represent the smallest allowable value for the voltage at the second network terminal 110. As previously discussed in consideration of the possible structural faults, the actual measured voltage may differ from the reference common mode voltage at the network terminals 108, 110 if a structural fault is present. The structural fault also affects the actual voltage at the second network terminal 110 in an analogous manner. The actual voltage at the second network terminal 110 can be measured via the third sensor unit 264 as a second measurement voltage.

If the driver unit 124 is enabled such that the driver unit 124 actually or attempts to drive the predefined reference voltage at the network terminals 108, 110, the third sensor unit 264 may compare the second measurement voltage to the seventh reference voltage, the eighth reference voltage, and/or a further, ninth reference voltage. Based on the at least one resulting comparison result, the third sensor unit 264 may detect a possible structural fault.

In an example, the third sensor unit 264 may comprise a seventh comparator 244 and a seventh voltage source 256. The seventh voltage source 256 may be configured to generate the seventh reference voltage. Further, the test unit 106 (and/or the third sensor unit 264) may be configured such that the second terminal connection 306 is coupled to the seventh comparator 244. Further, the seventh voltage source 256 may be coupled to the seventh comparator 244. In an example, the seventh comparator 244 is configured such that the seventh comparator 244 triggers if the second measurement voltage is greater than the seventh reference voltage. At least in this case, the third sensor unit 264 senses the second measurement voltage through the seventh comparator 244. If the second measurement voltage is greater than the seventh reference voltage, then this relationship implies a short circuit either between the network terminals 108, 110 of the primary network node 100 or a short circuit between the network lines 112, 114. The short circuit between the network terminals 108, 110 or the short circuit between the network lines 112, 114 may be referred to as a second short circuit. In an example, the third sensor unit 264 may be configured such that the third sensor unit 264 detects the second short circuit by triggering the seventh comparator 244.

In an example, the third sensor unit 264 may comprise an eighth comparator 246 and an eighth voltage source 258. The eighth voltage source 258 may be configured to generate the eighth reference voltage. Further, the test unit 106 (and/or the third sensor unit 264) may be configured such that the second terminal connector 306 is coupled to the eighth comparator 246. Further, the eighth voltage source 258 may be coupled to the eighth comparator 246. In an example, the eighth comparator 246 is configured such that the eighth comparator 246 triggers if the second measurement voltage is less than the eighth reference voltage. At least in this case, the third sensor unit 264 senses the second measure voltage via the eighth comparator 246. If the second measure voltage is less than the eighth reference voltage, then this relationship implies a break in one of the network lines 112, 114, particularly a break in the second network line 114. The interruption may also be referred to as a second break. In an example, the third sensor unit 264 is configured such that the third sensor unit 264 detects the second break by triggering the eighth comparator 246.

In an example, the third sensor unit 264 may comprise a ninth comparator 248 and a ninth voltage source 260. The ninth voltage source 260 may be configured to generate the ninth reference voltage. The ninth reference voltage may be less than the eighth reference voltage. Further, the test unit 106 (and/or the third sensor unit 264) may be configured such that the second terminal connection 306 is coupled to the ninth comparator 248. Further, the ninth voltage source 264 may be coupled to the ninth comparator 248. In an example, the ninth comparator 248 is configured such that the ninth comparator 248 triggers if the second measurement voltage is less than the ninth reference voltage. At least in this case, the third sensor unit 264 senses the second measurement voltage through the ninth comparator 248. If the second measurement voltage is less than the ninth reference voltage, then this relationship implies a termination fault. In an example, the third sensor unit 264 is configured such that the third sensor unit 264 detects the termination fault by triggering the ninth comparator 248.

In an example, the outputs of the comparators 244, 246, 248 are coupled to the second evaluation unit 262. In an example, the comparators 244, 246, 248 can output whether they have triggered (value of one, for example) or have not triggered (value of zero, for example).

If the second measurement voltage is greater than the seventh reference voltage (of the seventh reference voltage source 256), then it is also true that the second measurement voltage is greater than the eighth reference voltage and greater than the ninth reference voltage. As a result, in this case, only the seventh comparator 244 may trigger, while simultaneously the eighth comparator 246 and the ninth comparator 248 do not trigger. The evaluation unit 262 may be configured to detect the second short circuit in response to a triggering of the seventh comparator 244 and a simultaneous non-triggering of the eighth and ninth comparators 246, 248. The second short circuit may refer to a short circuit between the two network lines 112, 114 and/or a short circuit between the two network terminals 108, 110 of the primary network node 100.

If the second measured voltage is less than the eighth reference voltage (of the eighth reference voltage source 258) and greater than the ninth reference voltage (of the ninth reference voltage source 260), then it is also true that the second measured voltage is less than the seventh reference voltage (of the seventh reference voltage source 256). As a result, in this case, the eighth comparators 246 may trigger, while at the same time the seventh and ninth comparator 244, 248 do not trigger. The evaluation unit 262 may be configured, in response to a triggering of the eighth comparators 246 and a simultaneous non-tripping of the seventh and ninth comparator 244, 248 to detect a break in either of the network lines 112, 114, in particular a break in the second network line 114.

If the second measurement voltage is less than the ninth reference voltage (of the ninth reference voltage source 260), then it is also true that the second measurement voltage is less than the eighth reference voltage and less than the seventh reference voltage. As a result, in this case, the ninth comparator 248 may trigger, while at the same time the seventh comparator 244 does not trigger and eighth comparator 248 does trigger. The evaluation unit 262 may be configured to detect the termination fault in response to a triggering of the eighth and ninth comparator 246, 248 and a simultaneous and non-triggering seventh comparator 244.

Previously, it was explained that the evaluation unit 262 may be configured to determine whether a second short circuit, an open circuit, or a termination fault exists based on the results of the comparators 238, 240, 242. The comparators 238, 240, 242 may be referred to as the first set of comparators 238, 240, 242. The potential faults, such as a second short circuit, an interruption, or a termination fault, that the evaluation unit 262 may determine based on the results of the first group of comparators 238, 140, 242 is referred to as the first group of potential faults.

The evaluation unit 262 may further be configured to determine whether a third short circuit, open circuit, or termination fault exists based on the results of the comparators 244, 246, 248. The comparators 244, 246, 248 may be referred to as the second set of comparators 244, 246, 248. The potential faults, such as a third short circuit, an interruption, or a termination fault, that the evaluation unit 262 may determine based on the results of the second group of comparators 244, 246, 248 is referred to as the second group of potential faults.

In an example, the evaluation unit 262 may be configured to determine the second short circuit as a fault if the evaluation unit 262 determines the second short circuit for the first group of potential faults and if, at the same time, the evaluation unit 262 determines either no fault of the second group of potential faults or does not determine the third short circuit for the second group of potential faults.

In an example, the evaluation unit 262 may be configured to determine the third short circuit as a fault if the evaluation unit 262 determines the third short circuit for the second group of potential faults and if the evaluation unit 262, at the same time, determines either no fault of the first group of potential faults or not the second short circuit for the first group of potential faults.

In an example, the evaluation unit 262 may be configured to determine the first short circuit to be a fault if the evaluation unit 262 determines the second short circuit for the first group of potential faults and at the same time determines the third short circuit for the second group of potential faults. In this case, the determination of the first short circuit overrides the determination of the second and third short circuits.

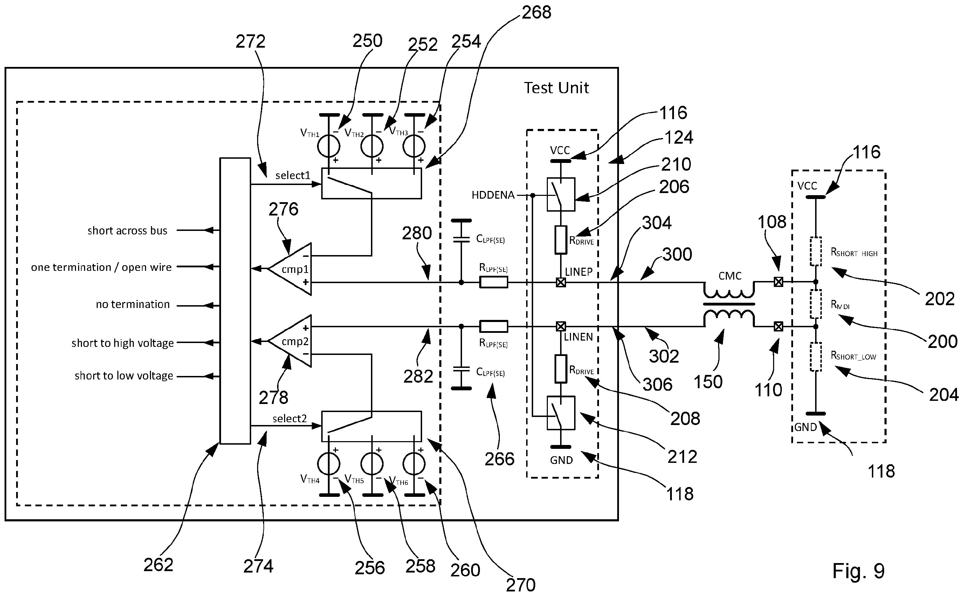

Figure 9 schematically illustrates an example of another embodiment of the test unit 106. For the test unit 106 of figure 9, reference is made to the preceding explanations, preferred features, technical effects and/or advantages in an analogous manner as they have been explained for the test unit 106 of figure 8 and/or 5. However, it should be noted that the fourth comparator 238, the fifth comparator 240 and the sixth comparator 242 have been replaced by a combination of a multiplexer 268 and a further comparator 276, the multiplexer 268 and the further comparator 276 performing the same function as previously explained in connection with the fourth, fifth and sixth comparators 238, 240, 242. It should also be noted that the seventh comparator 244, eighth comparator 246, and ninth comparator 248 have been replaced by a combination of a further multiplexer 270 and a further comparator 278, the multiplexer 270 and the comparator 278 performing the same function as previously explained in connection with the seventh, eighth, and ninth comparators 244, 246, 248.

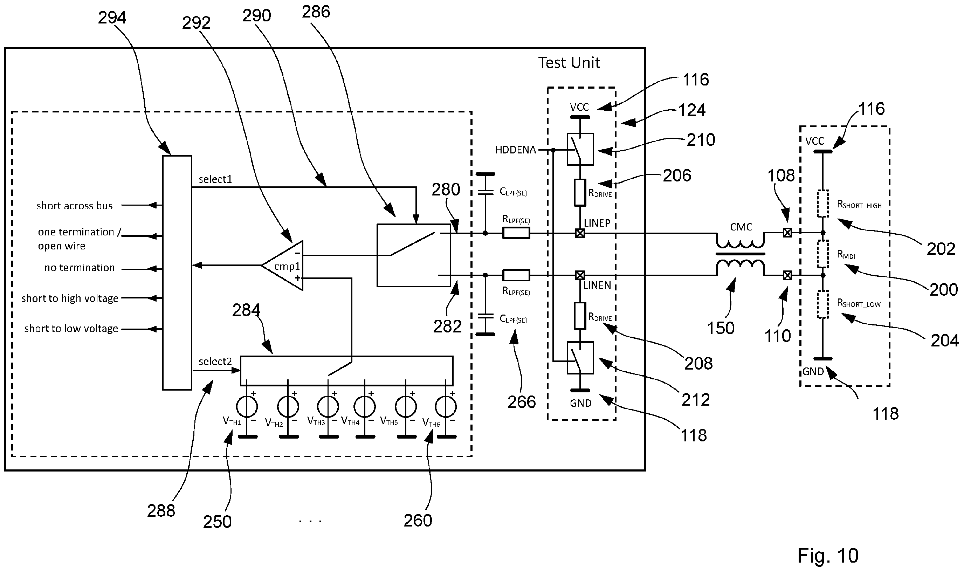

Figure 10 schematically illustrates a further embodiment of the test unit 106. For the test unit 106 of Figure 10, reference is made to the preceding explanations, preferred features, technical effects and/or advantages in an analogous manner as explained for the test unit 106 of Figures 7, 8, and 9. However, it should be noted that the two multiplexers 268, 270 are replaced by a multiplexer 284. Also, the two comparators 276, 278 are replaced by the combination of the switch 286 and the comparator 292, which perform the same function as the two comparators 276, 278.

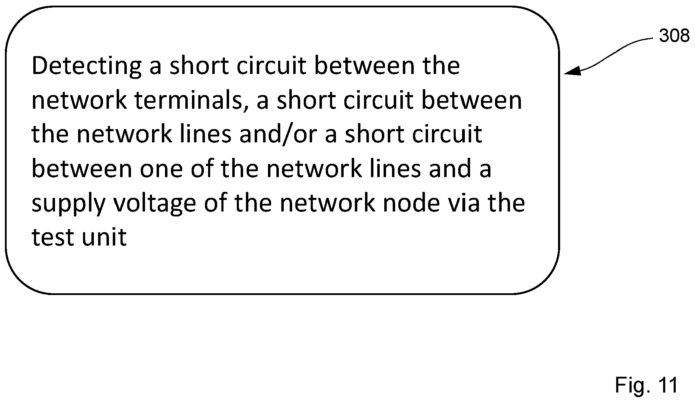

Figure 11 schematically illustrates a method 308 for the primary network node 100. The method comprises the step: Detecting a short circuit between the network terminals 108, 110, a short circuit between the network lines 112, 114 and/or a short circuit between one of the network lines 108, 110 and a supply voltage 116, 118 of the network node 100 via the test unit 106. For the method 308, reference is made to the advantageous explanations, preferred features, technical effects and advantages in an analogous manner as previously explained for the network node 100.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A network node comprising: a network interface for connecting to two-wire network lines, a transceiver, and a test unit, wherein the network interface comprises a first network terminal for connecting to a first of the two network lines and a second network terminal for connecting to a second of the two network lines, wherein the transceiver is coupled to the network terminals, wherein the transceiver is configured to generate a transmit signal at the network interface representing an Ethernet packet, wherein the test unit is galvanically connected coupled to the network terminals, and wherein the test unit is configured to detect a short circuit between the network terminals, a short circuit between the network lines and/or a short circuit between one of the network lines and a supply voltage of the network node, and/or to detect a break in at least one of the network lines.

2. The network node according to the preceding claim, wherein the transceiver is galvanically isolated coupled to the network terminals.

3. The network node according to any of the preceding claims, wherein the transceiver is capacitively coupled to the network terminals.

4. The network node according to claim 1, wherein the transceiver is galvanically connected coupled to the network terminals.

5. The network node according to any of the preceding claims, wherein the test unit is galvanically connected coupled to the network terminals via the transceiver.

6. The network node according to any of the preceding claims, wherein the test unit comprises a driver unit configured to cause a reference common mode voltage at the network terminals, wherein the test unit comprises a first sensor unit galvanically connected to both network terminals, wherein the first sensor unit configured to detect an actual common mode voltage at the network terminals, wherein the test unit is configured to detect a first short circuit between one of the network lines and a supply voltage of the network node based on a voltage difference between the reference common mode voltage and the actual common mode voltage.

7. The network node according to any of the preceding claims, wherein the test unit comprises the or a driver unit configured to cause a reference differential voltage and/or a reference common mode voltage at the network terminals, wherein the test unit comprises a second sensor unit galvanically connected to both network terminals, wherein the second sensor unit configured to directly or indirectly detect an impedance referred to as terminal impedance between the network terminals, wherein the test unit is configured to detect, based on the terminal impedance: a second short circuit between the network lines, and/or a first break in one of the network lines, and/or a termination error at the network lines and/or network terminals.

8. The network node according to the preceding claim, wherein the test unit is configured to detect the second short circuit if the terminal impedance is smaller than a first reference impedance, and/or wherein the test unit is configured to detect the first break if the terminal impedance is larger than the second reference impedance and in particular smaller than a third reference impedance, wherein the second reference impedance being larger than the first reference impedance, and/or wherein the test unit is configured to detect the termination error if the terminal impedance is greater than the third reference impedance.

9. The network node according to any of the preceding claims 1 to 5, wherein the test unit comprises a driver unit configured to cause a reference differential voltage and/or reference common mode voltage at the network terminals, wherein the test unit comprises a third sensor unit galvanically connected to the first network terminal, wherein the third sensor unit configured to detect a voltage referred to as the first measurement voltage at the first network terminal, the test unit being configured to detect based on the first measurement voltage: a first short circuit between one of the network lines and a supply voltage of the network node, and/or a second short circuit between the network lines, and/or a first break in one of the network lines, and/or a termination error at the network lines and/or network terminals.

10. The network node according to any of the preceding claims 1 to 5, wherein the test unit comprises a driver unit configured to cause a reference differential voltage and/or reference common mode voltage at the network terminals, wherein the test unit comprises a third sensor unit galvanically connected to the first network terminal, wherein the third sensor unit configured to detect a voltage referred to as the first measurement voltage at the first network terminal, wherein the test unit is configured to compare the first measurement voltage with a reference voltage resulting in a first comparison result, the test unit being configured to detect based on the first comparison result: a first short circuit between one of the network lines and a supply voltage of the network node, and/or a second short circuit between the network lines, and/or a first break in one of the network lines, and/or a termination error at the network lines and/or network terminals.

11. The network node according to any of the preceding claim 9 to 10, wherein the test unit is configured to detect the second short circuit if the first measurement voltage is smaller than a first reference voltage, and/or wherein the test unit is configured to detect the first break if the first measurement voltage is larger than the second reference voltage and in particular smaller than a third reference voltage, where the second reference voltage being larger than the first reference voltage, and/or wherein the test unit is configured to detect the termination error if the first measurement voltage is greater than the third reference voltage.

12. The network node according to the preceding claim, wherein the test unit comprises a first comparator to compare the first measurement voltage with the first reference voltage, wherein the test unit comprises a second comparator to compare the first measurement voltage with the second reference voltage, and wherein the test unit comprises a third comparator to compare the first measurement voltage with the third reference voltage.

13. The network node according to claim 11, wherein the test unit is configured to drive the reference voltage to each of the first reference voltage, second reference voltage and third reference voltage, and wherein the test unit comprises a comparator to compare the first measurement voltage with the reference voltage at each level driven by the test unit.

14. A system, comprising: a network node referred to as a primary network node according to any of the preceding claims, at least one another different network node referred to as secondary network node, and a two-wire network, wherein each secondary network node comprises a transceiver, wherein each secondary network node comprises a network interface for connecting to the network lines of the two-wire network, wherein the network interface of each secondary network node comprises a first network terminal for connecting to a first of the two network lines and a second network terminal for connecting to a second of the two network lines, wherein the transceiver of each secondary network node is coupled to the network terminals of the respective network node in a galvanically isolated manner, wherein the transceiver of each secondary network node is configured to generate a transmit signal at the network interface representing an Ethernet packet, and wherein each network node is galvanically connected coupled to the network lines via the associated network interface.

15. A method for a network node comprising a network interface for connecting to a two-wire network, a transceiver, and a test unit, wherein the network interface comprises a first network terminal for connecting to a first of the two network lines and a second network terminal for connecting to a second of the two network lines, wherein the transceiver is coupled to the network terminals, wherein the transceiver is configured to generate a transmit signal at the network interface representing an Ethernet packet, wherein the test unit is galvanically connected coupled to the network terminals, and wherein the method comprises the step of: Detecting a short circuit between the network terminals, a short circuit between the network lines and/or a short circuit between one of the network lines and a supply voltage of the network node via the test unit.
